# EUROPEAN PATENT APPLICATION

(11) **EP 3 413 694 A1**
(43) Date of publication of application: **12.12.2018**
(21) Application number: 18173456.7
(22) Date of filing: 21.05.2018
(51) Int. Cl.: H05K 3/12, H05K 3/38, C09D 133/14, H05K 1/03

(54) **FABRICATION OF ELECTRONIC PRODUCTS USING FLEXIBLE SUBSTRATES**

(30) Priority: 06.06.2017 US 201715615449
(71) Applicant: Xerox Corporation, Webster, NY 14580 (US)
(72) Inventor: WU, Jin, Rochester, NY 14621 (US); MA, Lin, Pittsford, NY 14534 (US)
(74) Representative: Gill Jennings & Every LLP

(57) **Abstract**

Disclosed is a fabrication method for electronic products, comprising planarization coating of a flexible substrate using a radiation curable composition.

## Description

### TECHNICAL FIELD

This disclosure is generally directed to a fabrication method for electronic products using flexible substrates.

### BACKGROUND

The use of flexible substrates has enabled improvement and innovation of electronic products not possible with conventional silicone substrates. Additionally, the use of flexible substrates has enabled fabrication by roll-to-roll techniques, for continuous, high speed, printing over large substrate areas. This technology, however, is not without its challenges.

For example, the surface quality of flexible substrates is essential to product quality and yield. Flexible substrates, such as polyethylene naphthalate (PEN) and polyethylene terephthalate (PET), which may be desirable for their relatively low cost, are typically limited to low processing temperatures and may have high coefficients of thermal expansion (CTE). Processing PEN or PET at moderate temperatures may increase surface roughness due to migration of oligomers to the surface. This roughness may degrade product quality and performance. As such, there is a need for improved fabrication methods in the manufacturing of flexible electronic products.

### SUMMARY

Various inventive features are described below that can each be used independently of one another or in combination with other features.

In accordance with various embodiments, disclosed is a fabrication method for an electronic product, comprising: coating a flexible substrate with a radiation curable composition; curing the radiation curable composition to form a planarized substrate having a cured layer; and applying at least one active layer to the planarized substrate, the active layer comprising an electroactive component, a photoactive component, or combinations thereof. In one aspect, the radiation curable composition is UV curable. In another aspect, the method comprises winding the flexible substrate on a roller. In yet another aspect, the radiation curable composition comprises a reaction curable diluent, a resin, and a photoinitiator. In still another aspect, the radiation curable composition comprises a polyether-modified acrylate oligomer, an ethoxylated trimethylolpropane triacrylate, or combinations thereof. In yet another aspect, the polyether-modified acrylate oligomer is an ethoxylated trimethylolpropane triacrylate, or combinations thereof. In still another aspect, the polyether-modified acrylate oligomer is an ethoxylated trimethylolpropane triacrylate such as LAROMER® LR 8863 from BASF, SR-502 from SARTOMER, SR-415 from SARTOMER, or combinations thereof. In yet another aspect, the radiation curable composition comprises a reaction curable diluent having the general structure: 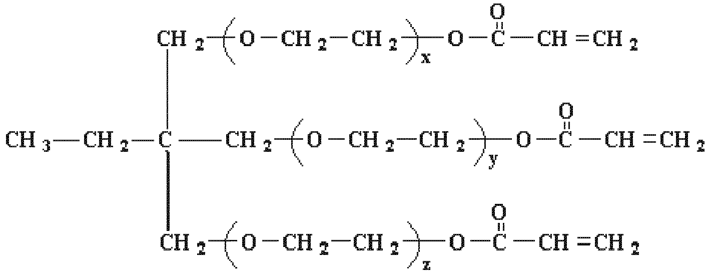 wherein, x is from about 1 to about 10, y is from about 1 to about 10, z is from about 1 to about 10, and x+y+z is from about 3 to about 24. In still another aspect, the radiation curable composition comprises a high viscosity resin, comprising a polyester acrylic resin. In yet another aspect, the high viscosity resin has a viscosity (at 23 °C) of from about 10,000 cps to about 200,000 cps. In yet another aspect, the high viscosity resin comprises LAROMER® PE 9079 or LAROMER®PE55F. In still another aspect, the radiation curable composition comprises a polyether-modified acrylate oligomer and polyester acrylic resin in a respective weight ratio from about 99/1 to about 30/70.

In accordance with further embodiments, disclosed is a fabrication method for an electronic product, comprising: coating a flexible substrate with a radiation curable composition comprising a reaction curable diluent, having the general structure: 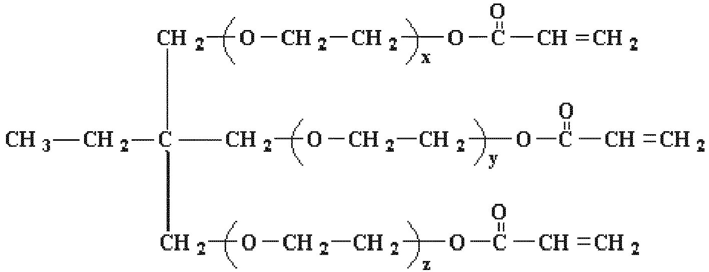 wherein, x is from about 1 to about 10, y is from about 1 to about 10, z is from about 1 to about 10, and x+y+z is from about 3 to about 24. In one aspect, the method comprises roll-to-roll processing of the flexible substrate. In another aspect, the method further comprises curing the radiation curable composition onto the flexible substrate. In yet another aspect, the radiation curable composition further comprises a resin and a photoinitiator.

In accordance with further embodiments, disclosed is a fabrication method for an electronic product, comprising: coating a flexible substrate with a radiation curable composition comprising a reaction curable diluent, and a resin, wherein the reaction curable diluent comprises a polyether-modified acrylate oligomer and/or ethoxylated trimethylolpropane triacrylate. In one aspect, the method further comprises: curing the radiation curable composition to form a planarized substrate having a cured layer; and applying at least one active layer to the planarized substrate, the active layer comprising a photoactive compent, an electroactive component, or a combination thereof. In another aspect, the fabrication method comprises roll-to-roll fabrication, wherein the flexibe substrate is wound upon a roller. In yet another aspect, the resin comprises polyester acrylic resin. In yet another aspect, the reaction curable diluent and the resin are present in a weight ratio of about 99/1 to about 30/70. In still another aspect, the radiation curable composition further comprises a photoinitiator, and the resin comprises a polyester acrylic resin.

### BRIEF DESCRIPTION OF THE FIGURES

The drawings described herein are for illustration purposes only and are not intended to limit the scope of the present disclosure in any way. The present disclosure will become more fully understood from the detailed description and the accompanying drawings wherein:
FIG. 1 depicts a process flow diagram of a fabrication method using a flexible substrate, in accordance with various embodiments;
FIG. 2 represents a fabricated product, in accordance with various embodiments;
FIG. 3 depicts, in isometric view, a roll-to-roll fabrication apparatus, in accordance with various embodiments.

### DETAILED DESCRIPTION

All ranges and ratio limits disclosed herein may be combined. Ranges disclosed herein include, unless specifically indicated, all endpoints and intermediate values.

Unless specifically stated otherwise, references to "a", "an", and/or "the" may include one or more than one and that reference to an item in the singular may also include the item in the plural. It is to be understood that the phrases "one or more" and "at least one" refer, for example, to instances in which one of the subsequently described circumstances occurs, and to instances in which more than one of the subsequently described circumstances occurs.

The term "optional" or "optionally" refer, for example, to instances in which subsequently described circumstances may or may not occur, and include instances in which the circumstance occurs and instances in which the circumstanced do not occur. The term "about" used in connection with a quantity is inclusive of the stated value and has the meaning dictated by the context (for example, it includes at least the degree of error associated with the measurement of the particular quantity). When used in the context of a range, the term "about" should also be considered as disclosing the range defined by the absolute values of the two endpoints. For example, the range "from about 2 to about 4" also discloses the range "from 2 to 4".

The detailed description of exemplary embodiments herein makes reference to the accompanying drawings, which show exemplary embodiments by way of illustration and its best mode, and not of limitation. While these exemplary embodiments are described in sufficient detail to enable those skilled in the art to practice the invention, it should be understood that other embodiments may be realized and that equivalents derived from logical chemical and mechanical changes may be made without departing from the spirit and scope of the invention. For example, the steps recited in any of the method or process descriptions may be executed in any order and are not necessarily limited to the order presented. Moreover, many of the functions or steps may be outsourced to or performed by one or more third parties. Furthermore, any reference to singular includes plural embodiments, and any reference to more than one component or step may include a singular embodiment or step. Also, any reference to attached, fixed, connected or the like may include permanent, removable, temporary, partial, full and/or any other possible attachment option. Additionally, any reference to without contact (or similar phrases) may also include reduced contact or minimal contact.

In the present disclosure, the term "radiation curable" generally refers to UV, electron beam, and/or visible light curable, as opposed to thermal (heat) curable.

The present disclosure is generally directed to a fabrication method for electronic products, comprising coating a flexible substrate using a radiation curable composition. The disclosure is further directed to a radiation curable composition, and to products fabricated using the disclosed radiation curable composition and/or fabrication method.

In embodiments, the radiation curable composition may be cured by UV energy, visible light, and/or electron beam (EB) as opposed to thermal, evaporative, or oxidative (air-dry) cure. The coating produced using the radiation curable composition is cleaner and faster to produce in comparsion to various thermally curable compositions. Additionally, for heat sensitive substrates such as paper and plastics, the radiation curable composition may have particular advantages over various thermally curable coating compositions, since very little or no heat is involved during the curing process.

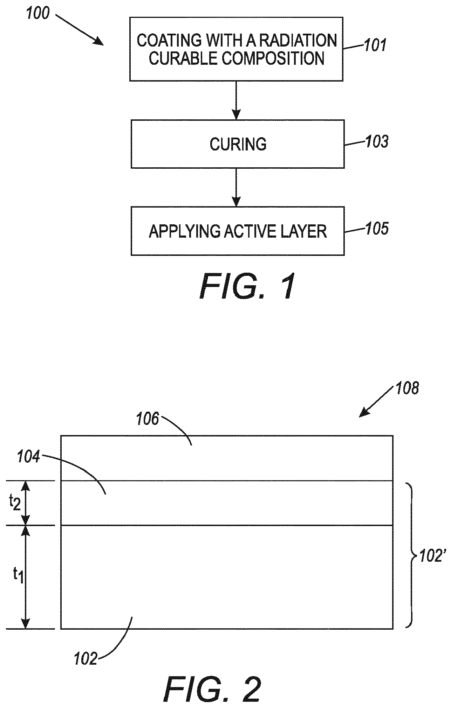

With reference to FIGS. 1 and 2, and in accordance with various embodiments, a fabrication method 100 (FIG. 1) for producing a flexible electronic product 108 (FIG. 2) may comprise coating a flexible substrate 102 (see FIG. 2) with a radiation curable composition (step 101 of FIG. 1). The method 100 may further comprise curing the radiation curable composition to planarize the substrate 102 (step 103), thereby forming a planarized substrate 102' comprising the flexible substrate 102 and a cured layer 104 that formed atop the substrate layer 102 after the step of curing the radiation curable composition. The method 100 may further comprise applying at least one active layer 106 comprising an electroactive and/or photoactive component (step 105). In certain embodiments, step 103 of curing may comprise UV curing. In certain other embodiments, step 103 may comprise electron beam curing. In various embodiments, active layer 106 may be applied onto the cured layer 104 of the planarized substrate 102', as shown in FIG. 2. In further embodiments, method 100 may comprise roll-to-roll fabrication techniques. Thus, any one or all of steps 101, 103, and 105 may be achieved by roll-to-roll processing.

In embodiments, the radiation curable composition may comprise a reaction curable diluent, and a resin. In embodiments, the radiation curable composition may further comprise a photoinitiator. In embodiments, the radiation curable composition may further comprise a solvent, other reactive agents, and/or an amine synergist.

In embodiments, the reaction curable diluent may comprise a poly ether-modified acrylate oligomer and/or ethoxylated trimethylolpropane triacrylate, having the following general structure: 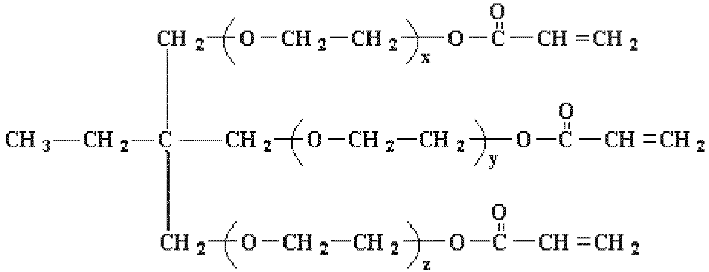 where x may be from about 1 to about 10, y may be from about 1 to about 10, z may be from about 1 to about 10, and x+y+z may be from about 3 to about 24.

The polyether-modified acrylate oligomer may be LAROMER® LR 8863 (molar mass=530 g/mol) from BASF; the ethoxylated trimethylolpropane triacrylate may be SR-502 (molar mass=692 g/mol) from SARTOMER, or SR-415 from SARTOMER.

The resin may be a high viscosity resin, and may comprise a polyester acrylic resin such as LAROMER® PE 9079 or PE55F from BASF. The resin may have a viscosity (at 23 °C) of from about 10,000 cps to about 200,000 cps, or from about 20,000 cps to about 100,000 cps.

A weight ratio between the reaction curable diluent and the high viscosity resin may be from about 99/1 to about 30/70, or from about 95/5 to about 60/40. In embodiments, the radiation curable composition may comprise polyether-modified acrylate oligomer and polyester acrylic resin in the weight ratios of from about 99/1 to about 30/70, or from about 95/5 to about 60/40.

In embodiments, the photoinitiator may comprise a mixture of 30% to 60% of diphenyl (2,4,6-trimethylbenzoyl)phosphine oxide, 25% of oligo[2-hydroxy-2-methyl-1-[4-(1-methylvinyl)phenyl]propanone], and 21% of 2-hydroxyl-2-methylpropiophenone, such as ESACURE® KTO46 from IGM Resins, and/or 2,4,6-trimethylbenzoyldiphenylphosphine oxide, such as LUCIRIN® TPO from BASF, and/or 2,4,6-trimethylbenzoylphenyl phosphinate, such as LUCIRIN® TPO-L from BASF. Such photoinitiators may be compatible with a long-wave XENON LH-830 UV curing system, and may be present in the radiation curable composition in an amount of from about 1 to about 10 weight percent of the radiation curable composition, or from about 2 to about 6 weight percent of the radiation curable composition, according to various embodiments. Examples of other photoinitiators that may be used in the radiation curable composition may include, but are not limited to, DAROCUR® 1173, BP, IRGACURE® 184, 819, 2100, 500, and/ or mixtures thereof, according to various embodiments.

In various embodiments, the radiation curable composition may include other reactive components such as hexanediol diacrylate, tripropyleneglycol diacrylate, dipropyleneglycol diacrylate, etc., and combinations thereof.

The radiation curable composition can also be diluted with various solvents such as esters, ketones, or aromatic hydrocarbons, according to various embodiments, wherein the solvents maybe completely flashed off or removed from the coating prior to curing, according to various embodiments.

In various embodiments, the radiation curable composition may further include an amine synergist, such as a low-molecular weight tertiary amine compounds, and/or an acrylated amine, to increase reactivity. The amine synergist may be, for example, triethanol amine and/or methyl diethanol amine. In embodiments, such amine synergist may be added to the composition in an amount of from about 0.1 to about 1 weight percent of the composition.

The radiation curable composition may be cured according to various curing systems. In embodiments wherein the radiation curable composition includes a photoinitiator, the curing system selected should be compatible with the particular photoinitiator used. Examples of suitable curing systems may include the XENON® lamp and mercury lamp UV curing systems, and various curing systems using electron beam or visible light. In embodiments, a XENON UV lamp may be used with a pulse rate of up to 100 pulses per second and up to 507 J/s energy. In embodiments, a curing system in a roll-to-roll fabrication process may operate at a speed of from about 10 feet/minute (0.051 m/s) to about 40 feet/minute (0.20 m/s) for low cycle time.

In embodiments, flexible substrate 102 may comprise any flexible material, such as, for example, flexible glass, stainless steel, paper, and plastics. In embodiments, flexible substrate 102 may comprise polyesters including polyethylene terephthalate (PET), polyethylene naphthalate (PEN), polyimide, polysulfone, polyvinyl chloride (PVC), polycarbonate (PC), polyethylene (PE), and the like.

In embodiments, a thickness "t₁" of the flexible substrate 102 may be from about 10 µm to about 300 µm, or from about 50 µm to about 150 µm. In embodiments, a thickness "t₂" of the cured layer 104 may be from about 0.5 µm to about 10 µm, or from about 2 µm to about 5 µm. In embodiments, the radiation curable composition may be coated onto substrates 102 via extrusion (i.e. slot extrusion) coating. However, various other coating methods, which are, or may become available with emerging technology, may be employed.

In embodiments, at least one additional layer 106, which may include an electroactive and/or photoactive layer may be applied onto the planarized substrate 102'. Layer 106 may be applied according to any printing or other manufacturing technique which is or may be availabe with emerging technology. Such techniques may include, for example, spin coating, blade coating, rod coating, dip coating, lithography or offset printing, gravure, flexography, screen printing, stencil printing, and stamping (such as microcontact printing), vacuum deposition or vacuum thermal evaporation, organic vapor phase deposition, magnetic sputtering, lift-up soft lithographic technique, laser ablation, ink-jet printing, etc. In roll-to-roll fabrications, such techniques may include, for example, magnetic sputtering, solution printing methods such as gravure printing, screen printing, etc.

Flexible electronic product 108 may comprise a flexible electronic and/or optical device, and/or a component of such device. Such product may be useful for a wide variety of applications, and may include, for example, stretchable semiconductors and electronic circuits, OLEDs, RFID, flexible displays, lighting devices, electrophoretic displays, packaging, textiles including body suits, medical devices, sensors, solar cell panels or sheets, flexible electronic paper, etc., and other such products, which are, or may become available with emerging technology.

In embodiments, the manufacture of printed electronic product 108 according to method 100 may be accomplished by any manufacturing technique which is or may become available with emerging technology. Manufacturing techniques may include, for example, batch processing, roll-to-roll processing, or other suitable techniques used with coventional non-flexible substrates. Method 100 comprising use of the disclosed radiation curable composition may be particlularly advantagious in facilitating and/or enabling roll-to-roll fabrication for certain products, leading to a significant improvement in productivity and reduced manufacturing cost.

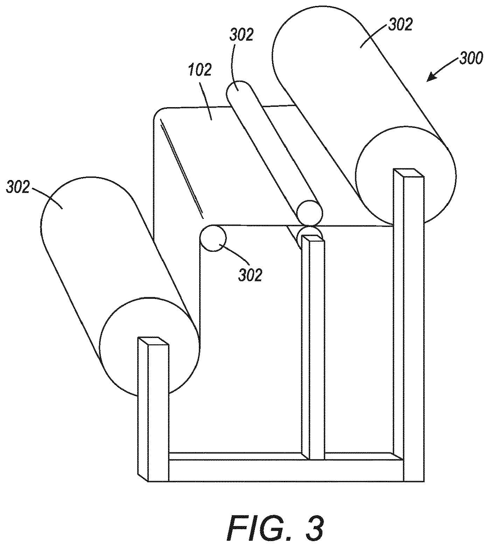

FIG. 3 illustrates a roll-to-roll manufacturing setup 300 comprising various rollers 302 for winding and unwinding flexible substate 102 for perforance of various operations of method 100, including coating, radiation curing, and application of the active layer 106.

### Example: Preparation of radiation curable compositions

First and second radiation curable coating, which were UV curable, were prepared in accordance with embodiments of the invention, as follows: The first coating ("coating #1") was prepared by mixing: LAROMER® LR 8863, LAROMER® PE 9079, and ESACURE® KTO46 together in a weight ratio of 90/10/4, respectively; the second coating ("coating #2) was prepared by mixing the same components, LAROMER® LR 8863, LAROMER® PE 9079, and ESACURE® KTO46, in a weight ratio of 80/20/4, respectively. Clear coating solutions were obtained for each of the coating mixtures. Each of the coating mixtures was draw-bar coated on 2mil (0.0508 mm) PEN substrate, and subsequently cured using the XENON LH-830 curing system with a curing speed of 20 feet/min (0.1016 m/s). The UV cured coatings were about 5 microns in thickness, and the coated PEN substrates remained flat with no curl. The surface roughness for each of the coated substrates was measured, and compared to the surface roughness for an uncoated PEN substrate, and to the surface roughness of a PET substrate coated with an acrylic (LUMIRROR® 41.31). The results are shown in Table 1, wherein Rₐ is the average roughness of a surface, R_{z} is the difference between the tallest "peak" and the deepest "valley" in the surface. The results indicate the PEN coated with either coating #1 or coating #2 to be significantly smoother than the uncoated PEN, and even smoother than the currently used acrylic coated PET.

**Table 1**

| | Lumirror 41.31 (acrylic coated PET) | Uncoated PEN | PEN coated with coating #1 | PEN coated with coating #2 |
|---|---|---|---|---|
| Rₐ (nm) | 6 | 65 | 4.7 | 3.8 |
| R_{z} (nm) | 50 | 608 | 34 | 32 |

Additionally, the coatings were found to have low shrinkage, excellent adhesion to a polyester substrate below the coating and to a silver electrode above the coating, and high chemical and thermal stability. Furthermore, the reduced shrinkage of the planarized layer leads to reduced internal stress and prevents curling of the substrate.

Based on the observed results, various substrates coated with the disclosed composition are expected to have excellent adhesion, with the surface roughness Rₐ of the planarized substrate 102' from about 1 nm to about 10 nm, and the surface roughness R_{z} of the planarized substrate 102' from about 10 nm to about 40 nm.

While the method and composition of the present invention have been described with reference to preferred embodiments, the present invention is not limited thereto. On the contrary, alternatives, changes or modifications may become apparent to those skilled in the art upon reading the foregoing description. Accordingly, such alternatives, changes and modifications are to be considered as forming a part of the invention insofar as they fall within the spirit and scope of the appended claims.

Systems and methods are provided. In the detailed description herein, references to "various embodiments", "one embodiment", "an embodiment", "an example embodiment", etc., indicate that the embodiment described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to affect such feature, structure, or characteristic in connection with other embodiments whether or not explicitly described. After reading the description, it will be apparent to one skilled in the relevant art(s) how to implement the disclosure in alternative embodiments.

Benefits, other advantages, and solutions to problems have been described herein with regard to specific embodiments. However, the benefits, advantages, solutions to problems, and any elements that may cause any benefit, advantage, or solution to occur or become more pronounced are not to be construed as critical, required, or essential features or elements of the invention. The scope of the invention is accordingly to be limited by nothing other than the appended claims, in which reference to an element in the singular is not intended to mean "one and only one" unless explicitly so stated, but rather "one or more". Moreover, where a phrase similar to "at least one of A, B, or C" is used in the claims, it is intended that the phrase be interpreted to mean that A alone may be present in an embodiment, B alone may be present in an embodiment, C alone may be present in an embodiment, or that any combination of the elements A, B and C may be present in a single embodiment; for example, A and B, A and C, B and C, or A and B and C. Furthermore, no element, component, or method step in the present disclosure is intended to be dedicated to the public regardless of whether the element, component, or method step is explicitly recited in the claims. No claim element herein is to be construed under the provisions of 35 U.S.C. 112(f) unless the element is expressly recited using the phrase "means for". As used herein, the terms "comprises", "comprising", or any other variation thereof, are intended to cover a non-exclusive inclusion, such that a process, method, article, or apparatus that comprises a list of elements does not include only those elements but may include other elements not expressly listed or inherent to such process, method, article, or apparatus.

It will be appreciated that variations of the above-disclosed and other features and functions, or alternatives thereof, may be desirably combined into many other different systems or applications. Also that various, presently unforeseen or unanticipated, alternatives, modifications, variations or improvements therein may be subsequently made by those skilled in the art which are also intended to be encompassed by the following claims.

## Claims

1. A fabrication method for an electronic product, comprising:
coating a flexible substrate with a radiation curable composition;
curing the radiation curable composition to form a planarized substrate having a cured layer; and
applying at least one active layer to the planarized substrate, the active layer comprising an electroactive component, a photoactive component, or combinations thereof.

2. The method of claim 1, wherein the radiation curable composition is UV curable.

3. The method of claim 1, wherein the method further comprises winding the flexible substrate on a roller.

4. The method of claim 1, wherein the radiation curable composition comprises a reaction curable diluent, a resin, and a photoinitiator.

5. The method of claim 1, wherein the radiation curable composition comprises a polyether-modified acrylate oligomer, an ethoxylated trimethylolpropane triacrylate, or combinations thereof.

6. A fabrication method for an electronic product, comprising:
coating a flexible substrate with a radiation curable composition comprising a reaction curable diluent, having the following structure: 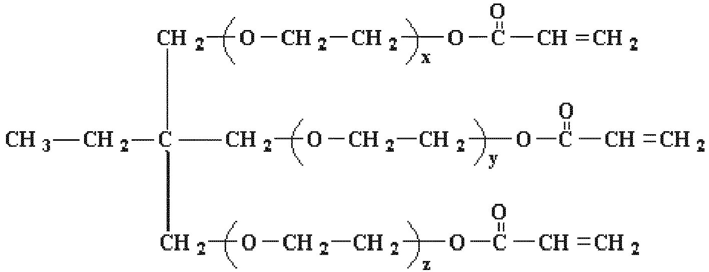 wherein, x is from about 1 to about 10, y is from about 1 to about 10, z is from about 1 to about 10, and x+y+z is from about 3 to about 24.

7. The method of claim 6, wherein the method comprises roll-to-roll processing of the flexible substrate.

8. The method of claim 6, further comprising curing the radiation curable composition onto the flexible substrate.

9. A fabrication method for an electronic product, comprising: coating a flexible substrate with a radiation curable composition comprising a reaction curable diluent, and a resin, wherein the reaction curable diluent comprises a polyether-modified acrylate oligomer and/or ethoxylated trimethylolpropane triacrylate.

10. The method of claim 9, further comprising: curing the radiation curable composition to form a planarized substrate having a cured layer; and applying at least one active layer to the planarized substrate, the active layer comprising a photoactive compent, an electroactive component, or a combination thereof.
